# EUROPÄISCHE PATENTSCHRIFT

(11) **EP 0 716 562 B1**
(45) Veröffentlichungstag und Bekanntmachung des Hinweises auf die Patenterteilung: **21.05.1997**
(21) Anmeldenummer: 94119273.4
(22) Anmeldetag: 07.12.1994
(51) Int. Cl.: H05H 1/46, H01J 37/32

(54) **Vorrichtung für Dünnschichtverfahren zur Behandlung grossflächiger Substrate**
Device for implementing a thin film process for the treatment of large area substrates
Dispositif pour la mise en oeuvre d'un procédé couche mince pour le traitement de substrats de grande surface

(43) Veröffentlichungstag der Anmeldung: 12.06.1996
(73) Patentinhaber: Balzers und Leybold Deutschland Holding Aktiengesellschaft, 63450 Hanau (DE)
(72) Erfinder: Gegenwart, Rainer, Dr., D-63322 Rödermark (DE); Gesche, Roland, Dr., D-63500 Seligenstadt (DE); Kretschmer, Karl-Heinz, Dr., D-63110 Rodgau (DE); Ritter, Jochen, Dipl.-Ing., D-35321 Laubach (DE); Noll-Daube, Sonja, D-63755 Alzenau (DE)

(56) Entgegenhaltungen:
- EP-A- 0 279 895
- EP-A- 0 398 832
- EP-A- 0 434 933
- EP-A- 0 527 290
- WO-A-92/22085
- US-A- 4 636 798

## Beschreibung

Die Erfindung betrifft eine Vorrichtung für Dünnschichtverfahren zur Behandlung großflächiger Substrate, typischerweise mit Substratabmessungen zwischen 500 - 1.000 mm mal 500 - 1.000 mm unter Anwendung eines Plasmas, das durch hochfrequente elektromagnetische Wellen, insbesondere Mikrowellen, angeregt wird und die elektromagnetischen Wellen aus einer Quelle mittels eines Wellenleiters, bestehend aus mindestens einem Hohlleiter sowie einer Hornantenne, in eine Plasmakammer eingekoppelt werden, welche durch ein für elektromagnetische Wellen durchlässiges Fenster von dem Wellenleiter getrennt ist.

Auf zahlreichen Gebieten der Technik werden sowohl in Beschichtungs- als auch Ätzanlagen Plasmaprozesse eingesetzt. Für die Erzeugung eines Plasmas können verschiedene Formen elektrischer Energie dienen. Beispielsweise ist es möglich, Gleichspannungen oder niederfrequente Wechselspannungen für die Erzeugung von Plasmen zu verwenden. Besonders vorteilhaft ist die Erzeugung von Plasma durch hochfrequente elektromagnetische Wellen, insbesondere Mikrowellen, weil hierbei unter anderem keine Elektroden benötigt werden, die verschmutzen und abgetragen werden können und weil das durch Mikrowellen erzeugte Plasma eine höhere Dichte von Ionen und Elektronen aufweist und daher auch auf höherem Druck gehalten werden kann als ein durch andere Verfahren erzeugtes Plasma.

Die von einer Mikrowellenquelle entsandten Wellen mit einer Frequenz von z.B. 2,45 GHz und einer Freiraumwellenlänge von ca. 12 cm werden üblicherweise mittels eines Wellenleiters übertragen und in einen Plasmaraum eingekoppelt, wobei der Wellenleiter in der Regel aus einem Hohlleiter und einer Antennenstruktur mit Koppelelementen oder einer Hornantenne besteht.

Es ist z.B. eine Einrichtung (OS DE 37 05 666) bekannt, die zum Herstellen eines Plasmas und zur Behandlung von Substraten darin geeignet ist. In dieser Einrichtung findet ein Mikrowellenleiter mit einem Hornstrahler (= Hornantenne) Anwendung, wobei drehbare Metallreflektoren innerhalb des Hornstrahlers und der Plasmakammer zur Beeinflussung der Feldverteilung eingesetzt werden. Die dadurch entstehende Vielzahl stehender Wellen wird auch als Multi-Mode-System bezeichnet. Durch diese Überlagerung vieler Einzelschwingungen entsteht ein Wellenfeld, das schon eine verbesserte Homogenität gegenüber der vom Hornstrahler abgestrahlten Mikrowellenkeule aufweist.

Zur Behandlung großflächiger Substrate, mit beispielsweise Substratabmessungen bis zu 1.000 auf 1.000 mm sind jedoch die Anforderungen an die Homogenität des Plasmas auf der gesamten Substratfläche weiter erhöht worden. So ist mit Nachteil festzustellen, daß die Anforderungen des Marktes an die Homogenität der mit oben genannter Einrichtung herstellbaren Schichten bezüglich Schichtdicke und Schichtzusammensetzung nicht mehr erfüllbar sind.

So liegt der Erfindung die Aufgabe zugrunde, eine Vorrichtung für die Erzeugung eines Plasmas mit Mikrowellen zu entwickeln, die für großflächige Substratabmessungen, gemäß obiger Definition, eine homogenere Leistungsverteilung der Mikrowellen und damit auch des Plasmas ermöglicht als bislang bekannte Vorrichtungen.

Ein großflächiges Substrat läßt sich in einer Koordinatenrichtung homogen behandeln, indem das Substrat linear an einer Plasmaquelle vorbeibewegt wird. Daraus folgt die Notwendigkeit, wenigstens in einer 2. Koordinatenrichtung, nämlich senkrecht zu der 1. Koordinatenrichtung, eine homogene Einkopplung der Mikrowellen zu erzeugen.

Diese Aufgabenstellung wird erfindungsgemäß gelöst, wie im Patentanspruch 1 beschrieben.
Mit Vorteil weisen die elektromagnetischen Wellen, beispielsweise Mikrowellen, beim Eintritt in die Plasmakammer eine annähernd ebene Phasenfront, sowie eine annähernd gleichförmige Amplitudenvertiefung auf.

Weitere Ausführungsmöglichkeiten und Merkmale sind in den Unteransprüchen näher beschrieben und gekennzeichnet.

Die Erfindung läßt verschiedene Ausführungsmöglichkeiten zu; eine davon ist schematisch in der anhängenden Zeichnung dargestellt, die eine Vorrichtung mit einem Mikrowellenhohlleiter, einem Rechteckhorn und einer Plasmakammer in perspektivischer Darstellung zeigt.

Aus einer nicht näher gezeigten Mikrowellenquelle werden die Mikrowellen M in einen Rechteckhohlleiter 1 eingespeist.
Dieser ist zunächst mit einer schlitzförmigen Verengung Q versehen und geht anschließend auf ein Rechteckhorn 2 über, das den Hohlleiter 1 in einer Koordinatenrichtung senkrecht zur Längsachse X-X dachförmig bis zur Höhe H aufweitet. Die beiden anderen, hier nicht gezeigten Seitenwände des Horns 2, sind parallel. An das Horn 2 schließt sich ein parallel-epipeder schmaler, schachtförmiger Übergangsbereich 3 an, der durch ein planes Quarzfenster 4 den Bereich atmosphärischen Drucks A im Hohlleiter 1 und im Horn 2 von dem Vakuumbereich V trennt. Rechteckhohlleiter 1, Rechteckhorn 2 und der Übergangsbereich 3 bilden zusammen den Wellenleiter W.

Durch das Quarzfenster 4 gelangt die Mikrowellenstrahlung M in eine Plasmakammer 5 und führt dem hier befindlichen Plasma 6 Leistung zu. Dieser Plasmakammer 5 schließt sich eine Substratkammer 7 an, durch die das zu behandelnde Substrat 8 hindurchbewegbar ist.

Die Phasengeschwindigkeit der Mikrowelle M ist in Bereichen mit verschiedener Apertur des Wellenleiters unterschiedlich. Dadurch wird an der Verbindungsstelle zwischen Rechteckhorn 2 und Übergangsbereich 3 eine Welle mit annährend kreisbogenförmiger Phasenfront P erzeugt und zwar entsprechend den beiden konkav ausgeformten Innenflächen 9,9' des Rechteckhorns 2, die vor der trichterförmigen Ausweitung K beiderseits des schachtförmigen Übergangsbereichs 3 vorgesehen sind. Am Ende des Übergangsbereichs 3 wird die Phasenfront wieder geradlinig und eben, so daß die Leistungsverteilung der Mikrowellen M beim Eintritt in die Plasmakammer 5 homogen ist.

Die Seitenwände von Hohlleiter 1 und Horn 2 erstrecken sich parallel zueinander, wobei im Übergangsbereich 3 zum einen eine stufenförmige Verengung der Außenwände des Wellenleiters W und zum anderen eine trichterförmige Aufweitung K der Aperturbreite vorgesehen ist.
Die Plasmakammer 5 weist in einem mittleren Bereich einen Abschnitt auf, in welchem zwei zweipolige Magnete 10,10' vorgesehen sind, die auf gegenüberliegenden Seiten und außerhalb der Kammer 5 angeordnet sind. In einem Magnetfeld, das durch die Magnetfeldlinien der beiden Magnete 10,10' entsteht, wird der Bereich des Plasmas 6 begrenzt.

Das Substrat 8 wird vor dem Plasma 6 und in Bewegungsrichtung B durch die Substratkammer 7 hindurchbewegt. Im seitlichen Anschluß an die Kammer 7 befinden sich weitere Vakuum-Kammerbereiche, die jedoch nicht näher dargestellt sind.

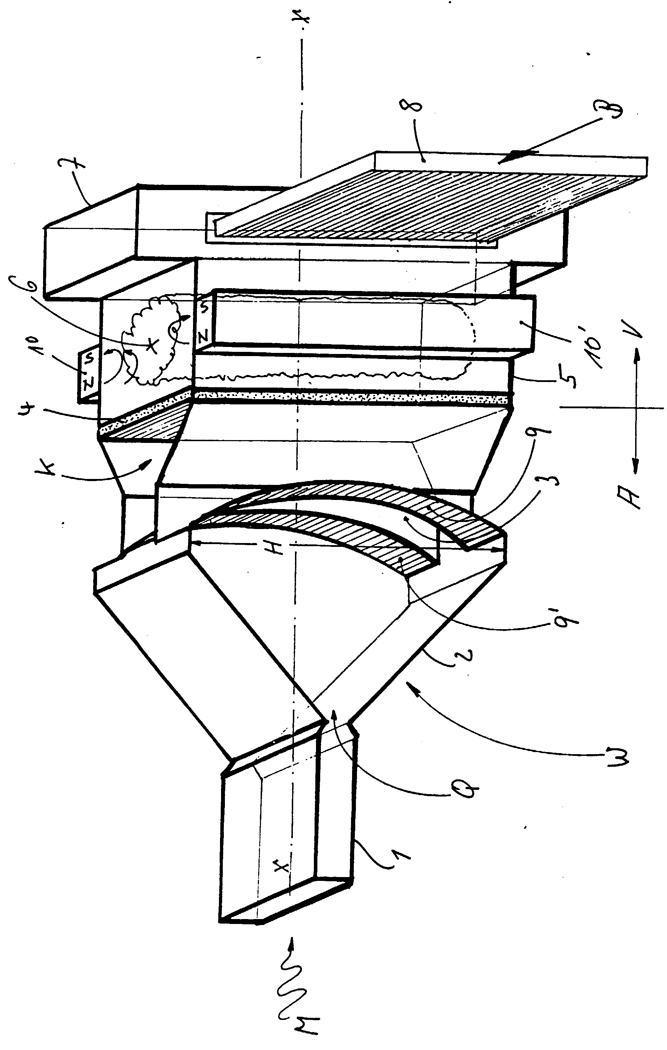

## Patentansprüche

1. Vorrichtung für Dünnschichtverfahren zur Behandlung großflächiger Substrate (8), unter Anwendung eines Plasmas (6), das durch hochfrequente elektromagnetische Wellen, insbesondere Mikrowellen (M), angeregt wird und die elektromagnetischen Wellen aus einer Quelle mittels eines Wellenleiters (W), bestehend aus mindestens einem Hohlleiter, sowie einer Hornantenne, in eine Plasmakammer (5) eingekoppelt werden, welche durch ein für elektromagnetische Wellen durchlässiges Fenster (4) von dem Wellenleiter getrennt ist, **dadurch gekennzeichnet,** daß der Wellenleiter eine im wesentlichen rechteckige Apertur aufweist, am Ende des Hohlleiters (1) ein Bereich mit einer z.B. schlitzförmigen Verengung (Q) vorgesehen ist, sich unmittelbar an diesen Bereich ein Rechteckhorn (2) anschließt und daß zwischen der größten Apertur des Rechteckhorns (2) sowie der Plasmakammer (5) ein schachtförmiger Übergangsbereich (3) vorgesehen ist und das Rechteckhorn (2) eine im wesentlichen flache parallelepipede Form aufweist, wobei die der Plasmakammer (5) zugekehrte, eine schlitzförmige Öffnung aufweisende Innenfläche (9,9') des Rechteckhorns (2) konkav ausgeformt ist und die Kammer (3) in ihrer Länge so bemessen ist, daß die elektromagnetischen Wellen, vorzugsweise Mikrowellen (M), beim Eintritt in die Plasmakammer (5) eine etwa ebene Phasenfront, die im wesentlichen parallel zur Ebene des Fensters verläuft, sowie eine annährend gleichförmige Amplitudenverteilung aufweisen.

2. Vorrichtung nach Anspruch 1, **dadurch gekennzeichnet,** daß der Aufbau des Wellenleiters (W) bezüglich seiner Längsachse X-X im wesentlichen spiegelsymmetrisch ausgeführt ist.

3. Vorrichtung nach den Ansprüchen 1 oder 2, **dadurch gekennzeichnet,** daß der Wellenleiter (W) in einem Bereich zwischen dem schachtförmigen Übergangsbereich (3) und der Plasmakammer (5) eine vorzugsweise trichterförmige Aufweitung (K) der Apertur aufweist.

4. Vorrichtung nach den Ansprüchen 1, 2 oder 3, **dadurch gekennzeichnet,** daß die trichterförmige Aufweitung des Rechteckhorns (2), sowie die Aufweitung (K) zwischen schachtförmigem Übergangsbereich (3) und Plasmakammer (5) jeweils nur in einer Koordinatenrichtung senkrecht zur Längsachse X-X des Wellenleiters ausgebildet sind.

5. Vorrichtung nach Anspruch 4, **dadurch gekennzeichnet,** daß die im wesentlichen dreieckige Projektionsfläche des Rechteckhorns (2) lotrecht zu der Projektionsfläche der Aufweitung (K) angeordnet ist.

## Claims

1. Device for thin film processes for the treatment of large area substrates (8), using a plasma (6) which is excited by high-frequency electromagnetic waves, in particular microwaves (M), and the electromagnetic waves are coupled into a plasma chamber (5) from a source by means of a waveguide (W), consisting of at least one hollow waveguide, and a horn aerial, which plasma chamber (5) is separated from the waveguide by a window (4) permeable to electro-magnetic waves, characterised in that the waveguide comprises an essentially rectangular aperture, at the end of the hollow waveguide (1) an area with an e.g. slit-shaped constriction (Q) is provided, a rectangular horn (2) butts directly against this area and that between the largest aperture of the rectangular horn (2) and the plasma chamber (5) a shaft-shaped transition area (3) is provided and the rectangular horn (2) has an essentially flat parallelepiped shape, wherein the inner surface (9, 9'), facing the plasma chamber (5) and comprising a slit-shaped opening, of the rectangular horn (2) is of concave construction and the compartment (3) is dimensioned as to its length in such a way that the electromagnetic waves, preferably microwaves (M), possess on entry into the plasma chamber (5) a roughly level phase front which runs essentially parallel to the plane of the window, as well as an approximately uniform amplitude distribution.

2. Device according to claim 1, characterised in that the set-up of the waveguide (W) is arranged essentially mirror-symmetrically in terms of its longitudinal X-X axis.

3. Device according to claims 1 or 2, characterised in that the waveguide (W) comprises in an area between the shaft-shaped transition area (3) and the plasma chamber (5) a preferably funnel-shaped widening (K) of the aperture.

4. Device according to claims 1, 2 or 3, characterised in that the funnel-shaped widening of the rectangular horn (2), as well as the widening (K) between shaft-shaped transition area (3) and plasma chamber (5), is constructed vertical to the longitudinal axis X-X of the waveguide in only one coordinate direction in each case.

5. Device according to claim 4, characterised in that the essentially triangular surface of projection of the rectangular horn (2) is disposed perpendicular to the surface of projection of the widening (K).

## Revendications

1. Dispositif pour la mise en oeuvre d'un procédé à couches minces pour le traitement de substrats (8) de grande surface, avec emploi d'un plasma (6) qui est excité par des ondes électromagnétiques à haute fréquence, en particulier des micro-ondes (M) et les ondes électromagnétiques provenant d'une source sont, au moyen d'un guide d'ondes (W), constitué d'au moins un guide creux, ainsi que d'une antenne cornet, couplées dans une chambre à plasma (5) qui est séparée du guide d'ondes par une fenêtre (4) transparente aux ondes électromagnétiques, caractérisé par le fait que le guide d'ondes présente une ouverture sensiblement rectangulaire, qu'à l'extrémité du conducteur creux (1) est prévue une zone présentant un rétrécissement (Q) par exemple en forme de fente, que dans cette zone se raccorde directement un cornet rectangulaire (2) et qu'entre la plus grande ouverture du cornet rectangulaire (2) et la chambre à plasma (5) est prévue une zone de transition (3) en forme de gaine et que le cornet rectangulaire (2) présente une forme de parallélépipède sensiblement plat, la surface intérieure (9, 9') du cornet rectangulaire (2) qui est orientée vers la chambre à plasma (5) et présente une ouverture en forme de fente avant une forme concave et la chambre (3) étant, en longueur, dimensionnée de façon que, lors de leur entrée dans la chambre à plasma (5), les ondes électromagnétiques, de préférence des micro-ondes (M), présentent un front de phase à peu près plan, sensiblement orienté parallèlement au plan de la fenêtre, ainsi qu'une répartition de l'amplitude à peu près uniforme.

2. Dispositif selon la revendication 1, caractérisé par le fait que la structure du guide d'ondes (W) est réalisée essentiellement symétrique par rapport à un plan passant par son axe longitudinal X-X.

3. Dispositif selon les revendications 1 ou 2, caractérisé par le fait que le guide d'ondes (W) présente, dans une zone située entre la zone de transition (3) en forme de gaine et la chambre à plasma (5), un élargissement (K) de l'ouverture de préférence en forme d'entonnoir.

4. Dispositif selon les revendications 1, 2 ou 3, caractérisé par le fait que l'élargissement, en forme d'entonnoir, du cornet rectangulaire (2) ainsi que l'élargissement (K) entre la zone de transition (3) en forme de gaine et la chambre à plasma (5) ne sont chacun prévus que dans une direction de coordonnées perpendiculaire à l'axe longitudinal X-X du guide d'ondes.

5. Dispositif selon la revendication 4, caractérisé par le fait que la projection, sensiblement triangulaire, du cornet rectangulaire (2) est perpendiculaire à la projection de l'élargissement (K).
